# EUROPEAN PATENT APPLICATION

(11) **EP 1 655 794 A2**
(43) Date of publication of application: **10.05.2006**
(21) Application number: 05022153.0
(22) Date of filing: 11.10.2005
(51) Int. Cl.: H01M 4/02, H01M 10/04, H01M 4/38, H01M 4/66, H01M 4/70, H05K 1/16

(54) **Double-electrode plate with electrical circuitry layer laminate and the secondary battery with the same**

(30) Priority: 03.11.2004 CN 200410088494
(71) Applicant: Antig Technology Co., Ltd., 114 Taipei (TW)
(72) Inventor: Chen, Cheng-Hsin, BeiTou Taipei (TW); Shen, Ko-Chen, NeiHu Taipei (TW); Shu, His-Ming, Hsin Chuang City Taipei County (TW)
(74) Representative: Viering, Jentschura & Partner

(57) **Abstract**

Double-electrode plate (10) comprises a first electrode layer (11), a second electrode layer (13) and a electrical circuitry layer (15). The first electrode layer (11) comprises a first substrate (111) and a first metal foil (113) covering upon the first substrate surface (111). The second electrode layer (13) comprises a second substrate (131) and a second metal foil (133) covering upon the second substrate surface (131). The electrical circuitry layer (15) is laminated between the first electrode layer (11) and the second electrode layer (13). The double-electrode plate (10) is laminated to form a compact structure in sequence from the top to bottom of the first metal foil (113), the first substrate (111), the electrical circuitry layer (15), the second substrate (131) and the second metal foil (133).
A secondary battery comprising this double-electrode plate (10) and electrolyte material.

## Description

### FIELD OF THE INVENTION

The present invention is related to a positive electrode plate and a negative electrode plate used for the secondary battery, especially to a double-electrode plate with electrical circuitry layer used for the secondary battery and further to a secondary battery with the same.

### BACKGROUND OF THE INVENTION

The used structure of secondary battery like Lithium rechargeable battery, nickel metal hydride rechargeable battery or Lithium polymer rechargeable battery is made by simply coating the electrolyte paste on the positive electrode plate and negative electrode plate and then placing in the order from top to bottom of positive electrode plate , isolation layer, negative electrode plate and isolation layer to form a battery core by rolling up and further injecting electrolyte and sealing process to compete the secondary battery manufacturing. The above secondary battery using the material of positive electrode plate and negative electrode plate has the structure of an individual component like the positive electrode plate by a long stripe and the negative electrode plate by another long stripe.

The inventor of the present invention breaks through the used structures of positive electrode plate and negative electrode plate to invent the double-electrode plate in advantage of light, thin, short, small and even miniaturized secondary battery.

### SUMMARY OF THE INVENTION

The first object of the present invention is to provide a double-electrode plate used for the secondary battery, which offers the function of positive electrode and the function of negative electrode and closely laminates the electrical circuitry layer to form a laminate structure of package.

The second object of the present invention is to provide a secondary battery, which uses the present invention double-electrode plate.

To achieve the above objects, the present invention is a double-electrode plate with electrical circuitry layer, comprising the first electrode layer, second electrode layer and electrical circuitry layer. The first electrode layer comprises a first substrate and a first metal foil covering upon the first substrate surface. The second electrode layer comprises a second substrate and a second metal foil covering upon the second substrate surface. The electrical circuitry layer is laminated between the first electrode layer and the second electrode layer. The double-electrode plate is laminated to form a compact structure in sequence from top to bottom of the first metal foil, the first substrate, the electrical circuitry layer, the second substrate and the second metal foil.

Furthermore, the present invention offers a secondary battery, comprising double-electrode plate, electrolyte material and encapsulated shell wherein the encapsulated shell utilizes the interior space to accommodate double-electrode plate and electrolyte material.

### BRIEF DESCRIPTION OF DRAWINGS

These and other modifications and advantages will become even more apparent from the following detained description of a preferred embodiment of the invention and from the drawings in which:
Figure 1 shows the elevational view of the present invention double-electrode plate;
Figure 2 shows the decomposed view of the present invention double-electrode plate; and
Figure 3 shows the sided cross sectional view of the secondary battery using the present invention double-electrode plate.

### DETAILED DESCRIPTION OF THE INVENTION

The present invention double-electrode plate 10, despite of being used for the positive electrode and negative electrode of the secondary battery like Lithium rechargeable battery, nickel metal hydride rechargeable battery or Lithium polymer rechargeable battery also places electrical circuitry layer 15 and therefore places the micro-sensor like a micro thermally sensitive resistor and MOSFET switch on electrical circuitry layer 15. Electrical circuitry layer 15 uses laminate structure and therefore enclosed inside the devices.

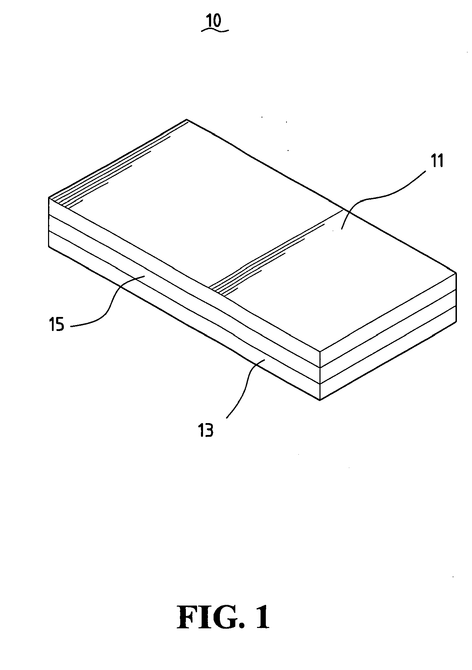

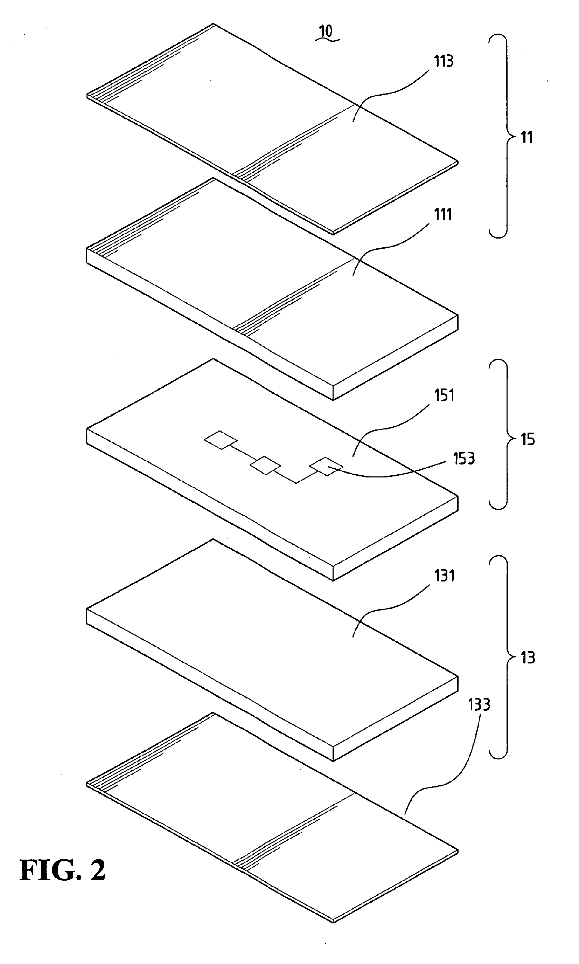

Figure 1 shows the elevational view of the present invention double-electrode plate and Fig. 2 shows the decomposed view of the present invention double-electrode plate. Double-electrode plate 10 mainly comprises first electrode layer 11, second electrode layer 13 and electrical circuitry layer 15 which are described below. First electrode layer 11 comprises first substrate 111 and first metal foil 113 covering upon the surface of first substrate 111. Second electrode layer 13 comprises second substrate 131 and second metal foil 133 covering upon second substrate 131. First substrate 111 and second substrate 131 use the material like the print circuit board (PCB), flexible print circuit (FPC) or flex-rollable material. First metal foil 113 on the surface of first substrate 111 and second metal foil 133 on the surface of second substrate 131 are possible to choose proper metal foil according to the condition producing the secondary battery, for instance of manufacturing the Lithium rechargeable battery, first metal foil 113 on the surface of first substrate 111 is copper foil and second metal foil 133 on the surface of second substrate 131 is aluminum foil.

Electrical circuitry layer 15 is laminated between first electrode layer 11 and second electrode layer 13, referring to Fig. 2. The present invention double-electrode plate 10 is piled up to form a compact sandwiched structure in sequence from top to down of first metal foil 113, first substrate 111, electrical circuitry layer 15, second substrate 131, second metal foil 133. Electrical circuitry layer 15 mainly comprises PCB 151 and at least above one electronic device 153 and possibly uses PCB as the material to form the circuitry on the PCB by etching process and then completes the manufacture of PCB 151. Again, electrical circuitry layer 15 is possible to place plural via holes (not shown) to possess the outward electrically connecting capability.

In the practice of electrical circuitry layer 15, the present invention considers the placed electronic devices 153 which are possible to have the highly thickness dependence to obstruct the closely sandwiched structure implementation of laminated piling up by the present invention double-electrode plate 10 and therefore the PCB 151 uses the structure like a concave surface to place those electronic devices 153 in the hollow region.

The present invention double-electrode plate 10 is possible to change into versatile shape by the physical property of the substrate. In case of using hard material as the first substrate 111 and second substrate 131, double-electrode plate 10 is possible to use planar plate structure. In case of using flex-rollable material as the first substrate 111 and second substrate 131, double-electrode plate 10 is possible to use rollable gyration structure or Z-shaped layered folded structure.

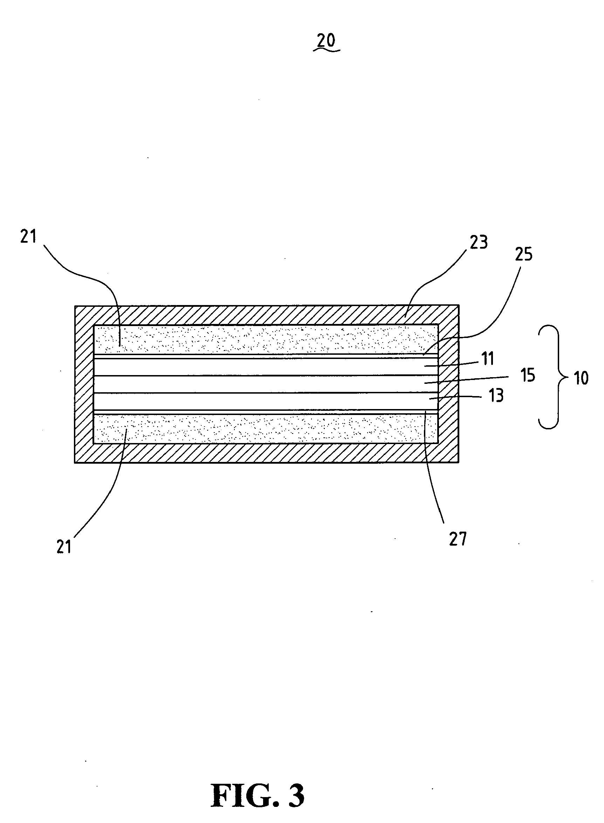

Figure 3 shows the sided cross sectional view of the secondary battery using the present invention double-electrode plate. The present invention secondary battery 20 mainly comprises double-electrode plate 10, electrolyte material 21 and encapsulated shell 23 which are described in details as below. Encapsulated shell 23 has an interior space inside to accommodate double-electrode plate 10 and electrolyte material 21 filled inside. Taking an example of producing Lithium rechargeable battery, copper foil 113 on the surface of first substrate 111 coats a thin layer of anode paste 25 like active material of Cobalt Lithium oxidant, and aluminum foil 133 on the surface of second substrate 131 coats a thin layer of cathode paste 27 like active material of carbon. Electrolyte material 21 filled inside the interior space is possible to be solid electrolyte, liquid electrolyte or glue electrolyte. The material of encapsulated shell 23 is possible to be the PCB or plastic.

The above embodiments are examples for interpretation, the right scope of the present invention should be on the basis of application claims and not limited by the above embodiments.

## Claims

1. A double-electrode plate with electrical circuitry laminate, comprising:
a first electrode layer, which comprises a first substrate and a first metal foil covering upon the first substrate surface;
a second electrode layer, which comprises a second substrate and a second metal foil covering upon the second substrate surface;
an electrical circuitry layer, which is laminated between the first electrode layer and the second electrode layer;
wherein the double-electrode plate is laminated in sequence to form a compact structure from top to bottom of the first metal foil, the first substrate, the electrical circuitry layer, the second substrate and the second metal foil.

2. The double-electrode plate with electrical circuitry laminate of claim 1, wherein the first substrate is a print circuit board (PCB) material, and the second substrate is a PCB material.

3. The double-electrode plate with electrical circuitry laminate of claim 1, wherein the first substrate is a flex-rollable material, and the second substrate is a flex-rollable material.

4. The double-electrode plate with electrical circuitry laminate of claim 1, wherein the first metal foil is a copper foil, and the second metal foil is an aluminum foil.

5. The double-electrode plate with electrical circuitry laminate of claim 1, wherein the electrical circuitry layer comprises a PCB, at least above one electronic device and soldering thereon.

6. The double-electrode plate with electrical circuitry laminate of claim 5, wherein the PCB is chosen from a PCB or a flexible print circuit (FPC).

7. A secondary battery, comprising:
a double-electrode plate, comprising:
a first electrode layer, comprising a first substrate and firs metal foil covering the first substrate surface;
a second electrode layer, comprising a second substrate and second metal foil covering the second substrate surface;
an electrical circuitry layer, which is laminated between the first electrode layer and the second electrode layer, wherein the double-electrode plate is laminated in sequence to form a compact structure from top to bottom of the first metal foil, the first substrate, the electrical circuitry layer, the second substrate and the second metal foil;
electrolyte material;
an encapsulated shell having an interior space inside to accommodate said double-electrode plate and said electrolyte material filled inside.

8. The secondary battery of claim 7, wherein the first substrate is a print circuit board (PCB) material, and the second substrate is a PCB material.

9. The secondary battery of claim 7, wherein the first substrate is a flex-rollable material, and the second substrate is a flex-rollable material.

10. The secondary battery of claim 7, wherein the first metal foil is a copper foil, and the second metal foil is an aluminum foil.

11. The secondary battery of claim 7, wherein the electrical circuitry layer comprises a PCB, at least above one electronic device and soldering thereon.

12. The secondary battery of claim 11, wherein the PCB is chosen from a PCB or a flexible print circuit (FPC).
